# EUROPÄISCHE PATENTSCHRIFT

(11) **EP 1 352 185 B1**
(45) Veröffentlichungstag und Bekanntmachung des Hinweises auf die Patenterteilung: **01.12.2004**
(21) Anmeldenummer: 02701176.6
(22) Anmeldetag: 09.01.2002
(51) Int. Cl.: F16H 61/00, H05K 7/00

(54) **HYDRAULISCHES KRAFTFAHRZEUG- GETRIEBESTEUERGERÄT MIT KUNSTSTOFF-HYDRAULIKVERTEILERPLATTE UND DARIN INTEGRIERTEN LEITERN**
HYDRAULIC MOTOR-VEHICLE GEARBOX CONTROL DEVICE WITH A PLASTIC HYDRAULIC DISTRIBUTION PLATE AND CONDUCTORS INTEGRATED THEREIN
COMMANDE HYDRAULIQUE DE BOITE DE VITESSES DE VEHICULE AUTOMOBILE, COMPRENANT UNE PLAQUE DE DISTRIBUTION HYDRAULIQUE EN MATIERE PLASTIQUE ET DES CONDUCTEURS INTEGRES DANS CETTE PLAQUE

(30) Priorität: 11.01.2001 DE 10101091
(43) Veröffentlichungstag der Anmeldung: 15.10.2003
(73) Patentinhaber: SIEMENS AKTIENGESELLSCHAFT, 80333 München (DE)
(72) Erfinder: ALBERT, Roland, 93047 Regensburg (DE)
(86) Internationale Anmeldenummer: PCT/DE2002/000043
(87) Internationale Veröffentlichungsnummer: WO 2002/055907

(56) Entgegenhaltungen:
- DE-A- 19 710 931
- DE-C- 19 811 610

## Beschreibung

Die Erfindung betrifft ein hydraulisches Kraftfahrzeug-Getriebesteuergerät mit einer Hydraulik-Verteilerplatte, in welcher sich Kanäle für Hydraulikflüssigkeit erstrecken, und Verfahren zu dessen Herstellung.

In den letzten Jahren werden vermehrt integrierte elektronisch-hydraulische Getriebesteuerungen in Kraftfahrzeug-(Kfz-)Getrieben eingesetzt. Integrierte Getriebesteuerungen zeichnen sich dadurch aus, dass die Steuerelektronik für das hydraulische Steuergerät innerhalb des Getriebes angeordnet ist. Dieses Konzept wird auch mit dem Begriff "Vorortelektronik" umrissen.

Neben den bekannten Vorzügen treten bei der Integration der Steuerelektronik in das Getriebe eine Reihe von Schwierigkeiten auf. Die Steuerelektronik muss gegen die im Getriebe herrschende Umgebung (Öl) geschützt werden. Weiterhin muss für eine gute Verlustleistungsabfuhr der Steuerelektronik gesorgt werden. Ein wesentlicher Gesichtspunkt ist die Signal- und Stromverteilung innerhalb des Getriebes, d.h. die Realisierung der elektrischen Verbindungen zwischen der Steuerelektronik und den Magnetventilen, Druckschaltern, Drucksensoren, Temperatursensoren und so weiter, sowie gegebenenfalls einem Getriebestecker, welcher das gesamte System mit einer elektrischen Peripherie außerhalb des Getriebegehäuses verbindet. Die elektrische Leitungsführung muss unter Berücksichtigung der baulichen Gegebenheiten eine möglichst optimale elektrische Entflechtung ermöglichen und darüber hinaus den hohen mechanische Beanspruchungen (Vibrationsbeschleunigungen bis etwa 33g) standhalten können.

Die mechanische Steuerung des Getriebes wird durch ein hydraulisches Getriebesteuergerät bewirkt, welches die Verteilung, die Druckverstärkung und die Volumenstromverstärkung der Hydraulikflüssigkeit sowie gegebenenfalls weitere Hydraulik-Aufgaben übernimmt. Das hydraulische Getriebesteuergerät umfasst eine oder mehrere Metallplatten (Ventilplatte, Kanalplatte), welche zur Verteilung der Hydraulikflüssigkeit von Kanälen durchzogen sind und ferner als Befestigungselemente für Aktuatoren (z.B. Magnetventile) und Sensoren dienen.

Die Steuerelektronik wird gegenwärtig als eigenständiges elektronisches Modul realisiert. Das Modul besteht aus einem dichten Metallgehäuse, in welchem die elektronische Schaltung untergebracht ist. Es wird z.B. auf der Ventilplatte oder Kanalplatte des hydraulischen Steuergeräts montiert, wobei die Verlustleistungsabfuhr über diese metallische Platte erfolgt. Zur Signal- und Stromverteilung im Getriebe wird zumeist eine Leiterplatte verwendet, welche auf der metallischen Platte befestigt ist. Eine andere Lösung besteht darin, die elektrischen Verbindungen über in Kunststoffteile eingebettete Stanzgitter oder Drähte zu realisieren. Schließlich können auch in dem Getriebe verlegte Kabelbäume als elektrische Verbindungselemente eingesetzt werden.

In der deutschen Patentschrift DE 43 44 584 C2 ist ein hydraulisches Getriebesteuergerät für ein Automatikgetriebe beschrieben. Das hydraulische Steuergerät besteht aus zwei Metallplatten, welche durch ein Zwischenblech getrennt sind. Die oben liegende Metallplatte dient zur Befestigung der Magnetventile. Auf dieser Metallplatte ist eine Leiterplatte angeordnet. Die Leiterbahnen der Leiterplatte bestehen aus gestanzten Blechteilen, welche in entsprechenden Aufnahmenuten der Leiterplatte versenkt angeordnet und gehaltert sind.

Der Erfindung liegt die Aufgabe zugrunde, ein hydraulisches Kraftfahrzeug-Getriebesteuergerät, insbesondere für den Einsatz in einem Automatikgetriebe, zu schaffen, welches eine einfache und mechanisch stabile Realisierung der elektrischen Leitungswege zur Anbindung elektrischer Komponenten des Gerätes ermöglicht. Ferner soll ein Verfahren zu dessen Herstellung angegeben werden.

Die Aufgabenstellung wird durch die Merkmale der unabhängigen Ansprüche gelöst.

Ausgangspunkt der Erfindung ist, dass es in Zukunft möglich sein wird, Gehäusebauteile des hydraulischen Getriebesteuergeräts als Kunststoffspritzgussteile auszuführen und serienmäßig einzusetzen. Die der Erfindung zugrundeliegende Idee besteht nun darin, hydraulische und elektrische Funktionen in einem einzigen solchen Kunststoffteil zusammenzufassen. Dies geschieht durch eine bauliche Integration sowohl der Kanäle für die Verteilung von Hydraulikflüssigkeit als auch der elektrischen Leiter in ein und demselben Kunststoffteil. Das Kunststoffteil bildet somit eine Hydraulik-Verteilerplatte des Getriebesteuergeräts und realisiert gleichzeitig ein Trägerelement, welchem die für die Signal- und Stromverteilung benötigten elektrischen Leiter angeformt oder eingearbeitet sind. Durch diese Doppelfunktion der aus Kunststoff bestehenden Hydraulik-Verteilerplatte entfällt das im herkömmlichen Getriebesteuergeräten vorhandene elektrische Verbindungselement.

Die bauliche Integration der elektrischen Leiter in die Hydraulik-Verteilerplatte kann entweder dadurch realisiert sein, dass die elektrischen Leiter in den Kunststoffkörper der Hydraulik-Verteilerplatte eingebettet und gegebenenfalls vollständig von dem Kunststoff umhüllt sind. Eine andere Möglichkeit besteht darin, dass die elektrischen Leiter an die Oberfläche der Hydraulik-Verteilerplatte anmetallisiert sind. In beiden Fällen werden Leiterwege mit hoher mechanischer Stabilität geschaffen.

Eine erste bevorzugte Ausgestaltung der Erfindung besteht darin, dass es sich bei den in die Hydraulik-Verteilerplatte eingebetteten Leitern um vergossene metallische Drähte, Stifte, Bänder oder Stanzgitter handelt. Die Leiter können beim Verguss entweder vollständig von dem Kunststoff umhüllt oder an ihrer Oberseite frei von Kunststoff bleiben.

Eine weitere, besonders bevorzugte Ausgestaltung der Erfindung kennzeichnet sich dadurch, dass die Hydraulik-Verteilerplatte als spritzgegossener MID- (Moulded Interconnected Device) Leitungsträger ausgeführt ist. Die als solche bekannte MID-Technik ermöglicht die Herstellung räumlich spritzgegossener Leitungsträger - hier die Hydraulik-Verteilerplatte - in welcher die Leiter integriert sind. Die MID-Technik ermöglicht sowohl den Aufbau von metallischen Leitern an der Oberfläche der Hydraulik-Verteilerplatte als auch die Realisierung von elektrischen Leitern, welche von dem Kunststoffmaterial der Hydraulik-Verteilerplatte (radial) vollständig umhüllt sind.

Vorzugsweise erstrecken sich die elektrischen Leiter zwischen einem an der Hydraulik-Verteilerplatte befestigten Steuerelektronikmodul und zwischen einem Magnetventil für die Hydrauliksteuerung. Eine weitere vorteilhafte Variante der Erfindung besteht darin, die elektrischen Leiter zur Verbindung eines an der Verteilerplatte angebrachten Getriebesteckers mit dem Steuerelektronikmodul einzusetzen.

Bei einem an der Hydraulik-Verteilerplatte befestigten Steuerelektronikmodul kennzeichnet sich eine besonders bevorzugte Variante der Erfindung dadurch, dass benachbart des Steuerelektronikmoduls in der Hydraulik-Verteilerplatte ein Kanal für Hydraulikflüssigkeit angeordnet ist. Durch die in unmittelbarer Nähe des Steuerelektronikmoduls vorbeifließende Hydraulikflüssigkeit wird eine wirksame Abfuhr der Verlustwärme des Steuerelektronikmoduls erreicht.

Weitere Vorteilhafte Ausgestaltungen der Erfindung sind in den Unteransprüchen angegeben.

Die Erfindung wird nachfolgend anhand von Ausführungsbeispielen und Varianten unter Bezugnahme auf die Zeichnung beschrieben, in dieser zeigt:
- Fig. 1: eine perspektivische Ansicht einer Hydraulik-Verteilerplatte mit daran angebrachten Magnetventilen und einem an der Platte befestigten Elektroniksteuermodul;
- Fig. 2: einen Ausschnitt der in Fig. 1 dargestellten Anordnung in Draufsicht;
- Fig. 3: eine Schnittdarstellung einer Variante der in den Fig. 1 und 2 dargestellten Anordnung entsprechend einen Schnitt entlang der Linie A-A in Fig. 2;
- Fig. 4: eine schematische Darstellung der Unterseite der in den Fig. 1 und 2 gezeigten Hydraulik-Verteilerplatte in Draufsicht;
- Fig. 5: eine Schnittdarstellung eines zweiten Ausführungsbeispiels der Erfindung entsprechend der Darstellung in Fig. 3; und
- Fig. 6: eine Schnittdarstellung eines weiteren Ausführungsbeispiels der Erfindung entsprechend der Darstellung in Fig. 3.

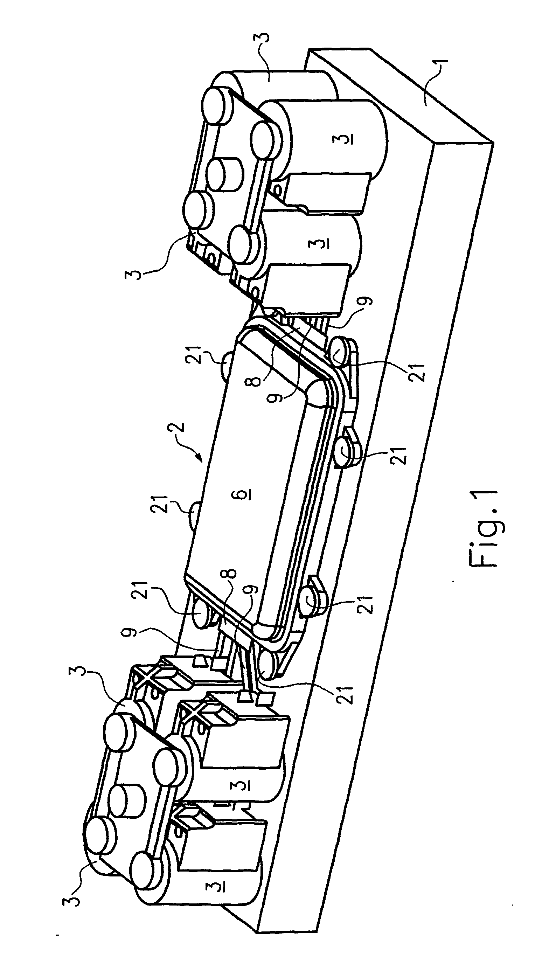

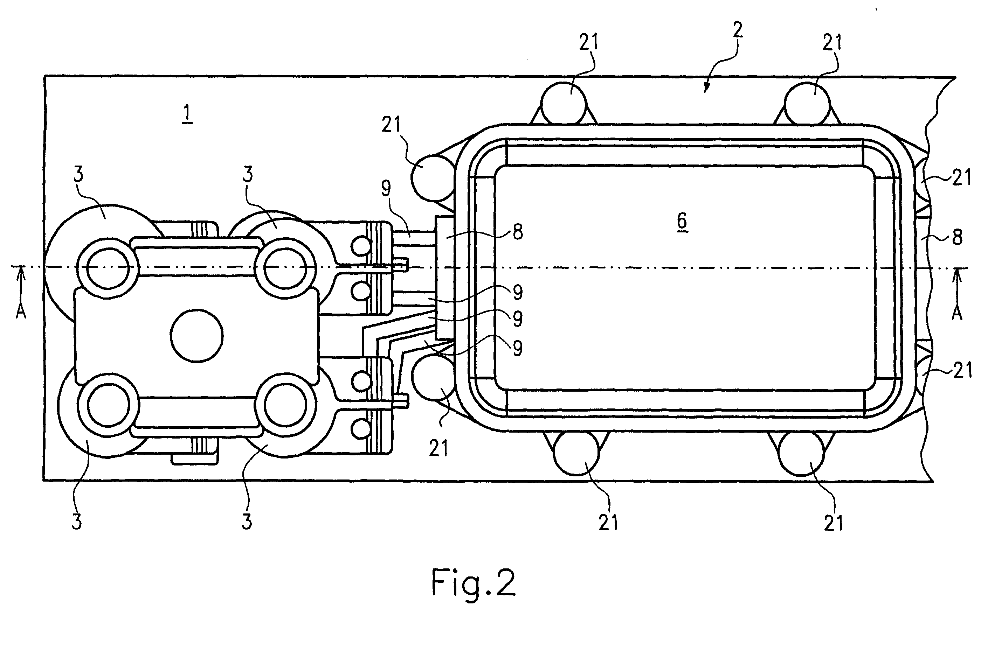

Gemäß den Fig. 1 und 2 sind auf einer länglichen, rechteckförmigen Ventilplatte 1, zwei Ventilbaugruppen bestehend aus jeweils vier Magnetventilen 3 und ein zwischen den beiden Ventilbaugruppen angeordnetes Steuerelektronikmodul 2 angebracht. Die Magnetventile 3 sind jeweils in Bohrungen eingesetzt, welche die Ventilplatte 1 durchsetzen und in Verbindung mit Druckmittelkanälen (in den Fig. 1 und 2 nicht erkennbar) stehen, welche in der Ventilplatte 1 verlaufen und im folgenden noch näher erläutert werden.

Die Ventilplatte 1 ist ein spritzgegossener Kunststoffkörper. Sie bildet einen Teil eines Hydraulik-Steuergehäuses eines hydraulischen Kfz-Getriebesteuergerätes. Das Getriebesteuergerät (mitsamt der Ventilplatte 1) ist beispielsweise im unteren Bereich des Getriebegehäuses befestigt, so dass es innerhalb der Ölwanne liegt.

Je nach den baulichen Gegebenheiten kann die Ventilplatte 1 eine andere Formgebung als in den Fig. 1 und 2 gezeigt aufweisen. Darüber hinaus kann das hydraulische Kfz-Steuergerät weitere Platten, Blechblenden, mechanische Betätigungselemente und so weiter umfassen. Üblicherweise ist eine sogenannte Kanalplatte (nicht dargestellt) an der den Ventilen 3 gegenüberliegenden Seite der Ventilplatte 1 angebracht. Die Kanalplatte, die z.B. ebenfalls aus Kunststoff oder aus Metall besteht, enthält weitere Druckmittelkanäle und ermöglicht die Verteilung von Hydraulikflüssigkeit in einer zweiten Ebene.

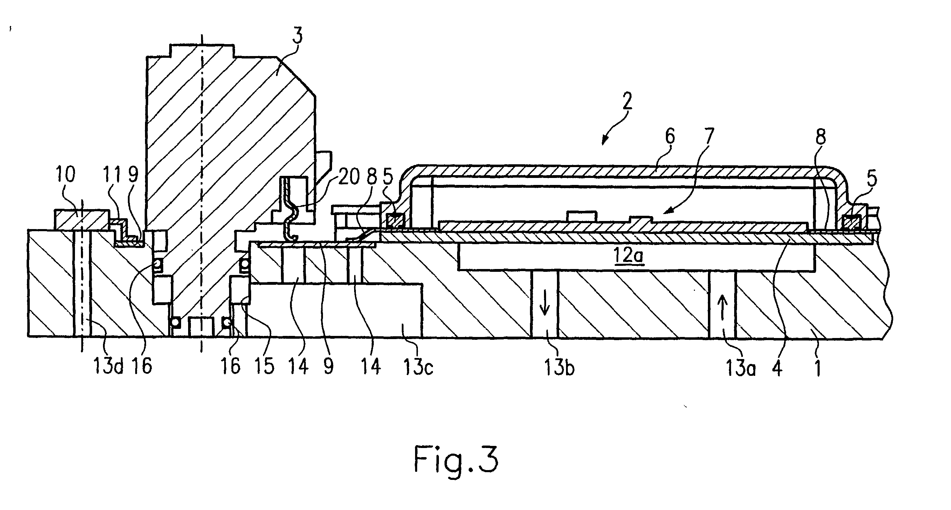

Im folgenden wird zur näheren Erläuterung der in Fig. 1 und 2 dargestellten Anordnung auch auf die Fig. 3 Bezug genommen. Die in Fig. 3 dargestellte Anordnung entspricht im wesentlichen der in den vorgehenden Figuren gezeigten Anordnung, wobei jedoch anstelle von zwei in Längsrichtung hintereinander angeordneten Magnetventilen 3 (siehe Fig. 1 und 2) hier lediglich ein Magnetventil 3 vorgesehen ist. Dieselben oder entsprechende Teile werden mit denselben Bezugszeichen bezeichnet.

Das Steuerelektronikmodul 2 weist eine metallische Bodenplatte 4 und einen über eine Formdichtung 5 dicht mit der Bodenplatte 4 gekoppelten Gehäusedeckel 6 auf. Die Anbringung des aus Metall oder Kunststoff bestehenden Gehäusedeckels 6 kann über Schrauben, Nieten, Pressstiftverbindungen 21 oder dergleichen erfolgen. Im dichten Innenraum des Steuerelektronikmoduls 2 befindet sich die Steuerelektronik. Die Steuerelektronik ist in Form eines bestückten Schaltungsträgers 7, beispielsweise Keramik-Leiterplatte, realisiert. Der Schaltungsträger 7 ist unmittelbar auf die Oberfläche der Bodenplatte 4 aufgeklebt.

Zur elektrischen Kontaktierung der Steuerelektronik dient eine flexible Leiterplatte 8, die den Schaltungsträger 7 umgibt und auf die Bodenplatte 4 auflaminiert (geklebt) ist. Die flexible Leiterplatte 8 verlässt das Modulgehäuse des Steuerelektronikmoduls 2 durch einen Dichtspalt zwischen der Bodenplatte 4 und der Formdichtung 5. Außerhalb des Modulgehäuses ist die flexible Leiterplatte 8 zu elektrischen Leitern 9 hingeführt, welcher in die Ventilplatte 1 integriert sind.

Bei den Leitern 9 kann es sich um ein Stanzgitter, Drähte, Stifte, Metallbänder etc. handeln. Die Leiter 9 können an ihrer Oberseite freiliegen, siehe Fig. 1 bis 3, oder vollständig von dem Kunststoff des Ventilplatte 1 ummantelt sein. Herstellungstechnisch können die Leiter 9 z.B. durch Einspritzen oder Vergießen in die Ventilplatte 1 baulich integriert sein. Ferner ist es auch möglich, dass die Leiter 9 durch andere Maßnahmen wie beispielsweise Einstemmen, Einkleben in Leiternuten oder dergleichen in die Ventilplatte 1 eingearbeitet sind.

Die in die Ventilplatte 1 eingearbeiteten Leiter 9 kontaktieren die Magnetventile 3 sowie andere elektrische Funktionselemente des Hydraulik-Steuergeräts. Zur elektrischen Kontaktierung der Magnetventile 3 sind jeweils Kontaktfedern 20 vorgesehen, welche mit einem definierten Druck auf die Oberfläche der Leiter 9 aufdrücken. Ferner ist ein Druckschalter 10 dargestellt, welcher über eine Stanzfahne 11 mit einem Leiter 9 elektrisch verbunden ist.

Die Ventilplatte 1 enthält Kanäle und Kammern, die von Hydraulikflüssigkeit durchströmt sind. Eine erste Kammer 12a liegt unmittelbar unter der Bodenplatte 4 und wird durch diese deckenseitig begrenzt. Hydraulikflüssigkeit strömt durch einen Kanal 13a in die Kammer 12a ein, durchströmt diese und fließt durch einen anderen Kanal 13b aus der Kammer 12a ab. Auf diese Weise wird eine wirkungsvolle Kühlung der Schaltungselektronik bewerkstelligt.

Ein weiterer Druckmittelkanal 13c verläuft in unmittelbarer Umgebung des Magnetventils 3, wobei in nicht näher dargestellter Weise das Magnetventil 3 eine Steuerung des Flüssigkeitsdurchsatzes durch den Kanal 13c bewirkt.

Ferner erstreckt sich durch die Ventilplatte 1 ein Kanal 13d zu dem Druckschalter 10 hin. Über den Kanal 13d erfasst der Druckschalter 10 einen Hydraulikflüssigkeitsdruck, welcher am Ausgang des Kanals 13d, d.h. an der Unterseite der Ventilplatte 1, herrscht.

Ferner sind in der Ventilplatte 1 Bohrungen 14 vorgesehen, welche an den Kontaktierungsbereichen der Kontaktfeder 20 und der flexiblen Leiterplatte 8 mit dem Leiter 9 letzteren rückseitig freilegen. Die Bohrungen 14 stellen Beleuchtungsöffnungen dar, durch welche mittels eines Laserstrahls die Kontaktfeder 20 und die flexible Leiterplatte 8 bei der Montage direkt an den Leiter 9 angeschweißt werden können.

Eine Ventilbohrung 15 bildet den Sitz für das Magnetventil 3, welches in die Ventilplatte 1 eingesetzt ist. Zur Abdichtung der Ventilplatte 1 gegen den Austritt von Hydraulikflüssigkeit dienen Formdichtungen 16, welche am Umfang des Ventilkörpers 3 in Höhe der Ventilbohrung 15 angebracht sind.

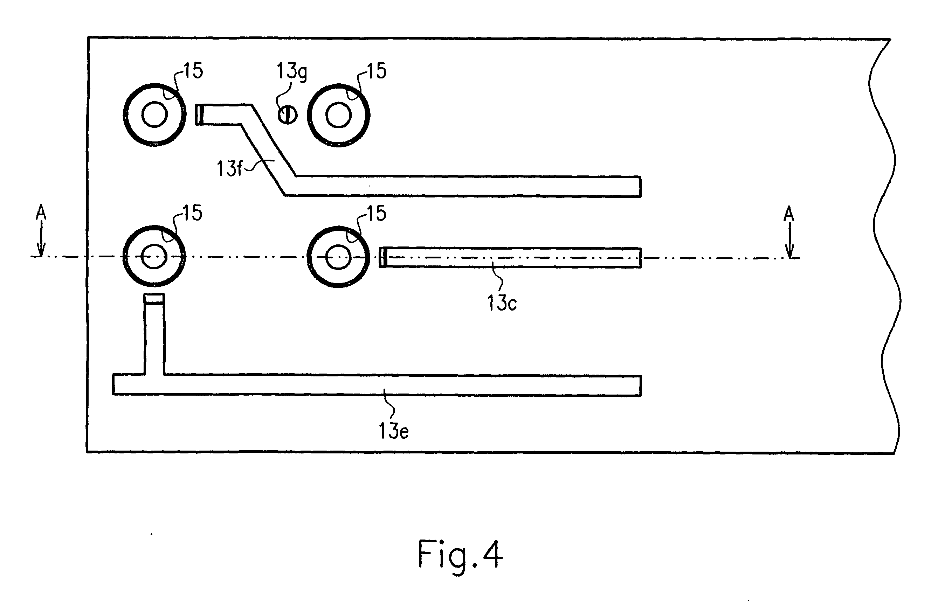

Fig. 4 zeigt die Unterseite der in Fig. 2 dargestellten Ventilplatte 1 zur Erläuterung des Verlaufs der Druckmittelkanäle. Neben dem Kanal 13c erstrecken sich weitere Horizontalkanäle 13e, 13f und ein vertikal verlaufender Stichkanal 13g zu den Ventilbohrungen 15 hin.

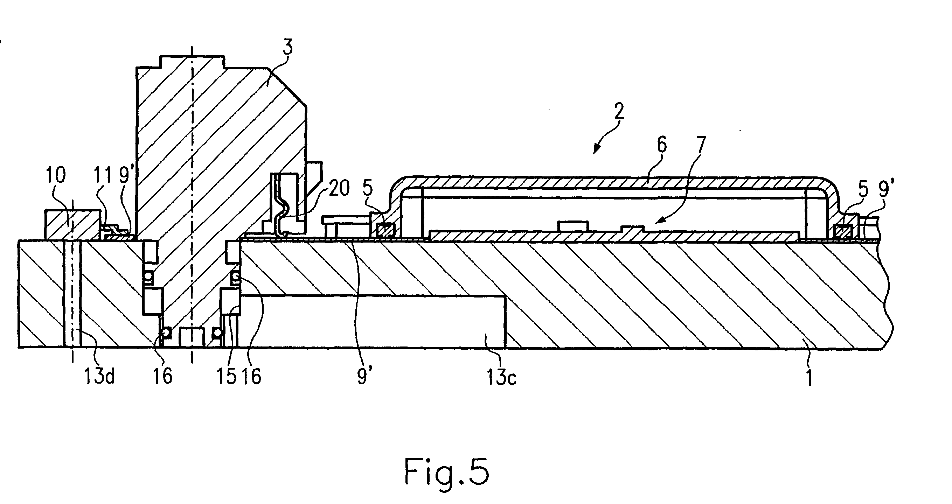

Fig. 5 zeigt ein weiteres Ausführungsbeispiel der Erfindung in Längsschnittdarstellung. Das zweite Ausführungsbeispiel unterscheidet sich von dem ersten Ausführungsbeispiel hauptsächlich dadurch, dass Leiter 9' mittels der MID-Technik in die Ventilplatte 1 eingearbeitet sind.

Die MID-Technik ermöglicht den Aufbau von Leiterstrukturen sowohl an der Oberfläche der Ventilplatte 1 als auch im Inneren des Ventilkörpers 1. In beiden Fällen werden zunächst elektrisch leitfähige, leiterbahnähnliche Kunststoffstrukturen aufgebaut (d.h. entweder auf der Oberfläche der Ventilplatte durch Aufspritzen und Strukturieren herausgebildet oder in das Innere der Ventilplatte eingegossen) und nachträglich metallisiert. Die Metallisierung kann beispielsweise durch Galvanisieren, d.h. Abscheiden von Metall an den leiterbahnähnlichen Kunststoffstrukturen, realisiert werden.

Bei dem in Fig. 5 gezeigten Ausführungsbeispiel ist der Schaltungsträger 7 direkt auf die Ventilplatte 1 aufgeklebt. Eine metallische Bodenplatte 4 entfällt. Die in die Ventilplatte 1 eingeformten Leiter 9' können zwischen der Oberfläche der Ventilplatte 1 und der Formdichtung 5 in den Innenraum des Steuerelektronikmoduls 2 hineingeführt werden, ohne dass dabei Undichtigkeiten im Bereich der Durchführung auftreten.

Die Kühlung der Steuerelektronik kann entsprechend dem ersten Ausführungsbeispiel (siehe Fig. 3) durch eine Kammer 12a und Druckmittelkanäle 13a, 13b erfolgen. Bohrungen 14 sind bei diesem Ausführungsbeispiel nicht erforderlich.

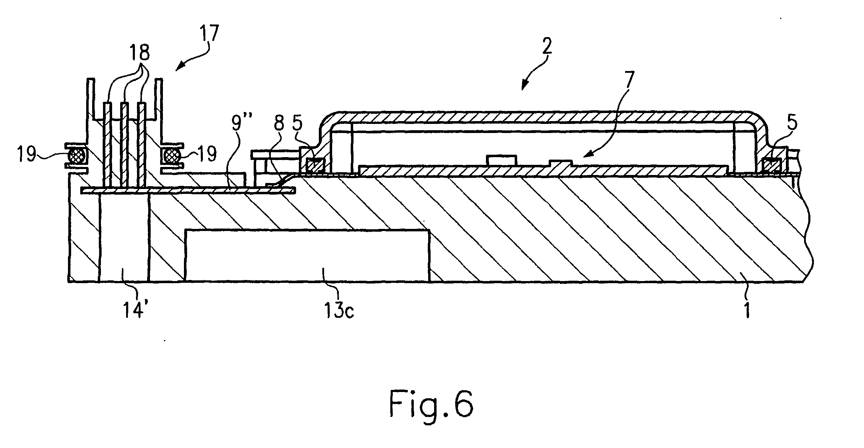

Fig. 6 zeigt ein weiteres Ausführungsbeispiel der Erfindung, bei welchem ein im Inneren der Ventilplatte 1 geführter Leiter 9'' das Steuerelektronikmodul 2 mit einem Getriebestecker 17 kontaktiert. Der Getriebestecker 17 ist einstückig mit der Ventilplatte 1 geformt und weist umspritzte Steckerstifte 18 auf, welche an ihrem einen Ende mit dem Leiter 9" verbunden sind, während sie an ihrem anderen Ende aus dem Steckerkörper 17 als Pins hervorstehen.

Im eingebauten Zustand ragt der Getriebestecker 17 durch eine Steckeröffnung in dem Getriebegehäuse hindurch, um dort mit einem komplementär geformten, außerhalb des Getriebes befindlichen Gegenstecker gekoppelt zu werden. Die Dichtigkeit dieser Durchführung wird durch einen den Getriebestecker 17 umlaufenden Dichtring 19 gewährleistet. Alternativ kann es sich bei dem Stecker 17 auch um einen internen Stecker handeln.

Eine Bohrung 14' im rückwärtigen Bereich des Getriebesteckers 17 ermöglicht das Ankontaktieren der Steckerstifte 18 an den elektrischen Leitern 9'' über eine Schweißung, Lötung oder andere Kontaktierungsverfahren. Alternativ hierzu können die elektrischen Leiter 9'' und die Stifte 18 auch einstückig, z.B. in Form gebogener Leiterdrähte, realisiert sein, wobei dann der Kontaktierungsschritt entfällt.

Eine weitere, nicht dargestellte Möglichkeit besteht darin, auch die Bodenplatte 4 im Rahmen des Herstellungsvorgangs (Spritzgießen) der Ventilplatte 1 in diese zu integrieren. Auch in diesem Fall kann die Bodenplatte 4 das Deckenelement einer Druckmittelkammer ähnlich der Kammer 12a bilden.

Die anhand der verschiedenen Ausführungsbeispiele beschriebenen Maßnahmen sind kombinierbar und ermöglichen stets, dass die Kunststoff-Ventilplatte 1 in Doppelfunktion als Element für die Verteilung von Hydraulikflüssigkeit und als Leiterträger wirkt.

## Patentansprüche

1. Hydraulisches Kraftfahrzeug-Getriebesteuergerät, mit einer aus Kunststoff bestehenden Hydraulik-Verteilerplatte (1), in welcher sich Kanäle (13a-f) für die Verteilung von Hydraulikflüssigkeit erstrecken, und
- in welcher elektrische Leiter (9, 9', 9'') des Getriebesteuergerätes eingebettet, insbesondere vollständig umhüllt sind und/oder
- an deren Oberfläche elektrische Leiter (9, 9', 9'') des Getriebesteuergerätes anmetallisiert sind.

2. Hydraulisches Kraftfahrzeug-Getriebesteuergerät nach Anspruch 1,
**dadurch gekennzeichnet,**
- **dass** es sich im Fall von in die Hydraulik-Verteilerplatte (1) eingebetteten Leitern (9, 9', 9'') um vergossene oder eingespritzte metallische Drähte, Stifte, Bänder oder Stanzgitter handelt.

3. Hydraulisches Kraftfahrzeug-Getriebesteuergerät nach Anspruch 1 oder 2,
**dadurch gekennzeichnet,**
- **dass** die Hydraulik-Verteilerplatte (1) als spritzgegossener MID-Leitungsträger ausgestaltet ist.

4. Hydraulisches Kraftfahrzeug-Getriebesteuergerät nach einem der vorhergehenden Ansprüche,
**dadurch gekennzeichnet,**
- **dass** sich die Leiter (9, 9') zwischen einem an der Hydraulik-Verteilerplatte (1) befestigten Steuerelektronikmodul (2) und zumindest einem Magnetventil (3) für die Hydrauliksteuerung erstrecken.

5. Hydraulisches Kraftfahrzeug-Getriebesteuergerät nach einem der vorhergehenden Ansprüche,
**dadurch gekennzeichnet,**
- **dass** sich die Leiter (9'') zwischen einem an der Hydraulik-Verteilerplatte (1) befestigten Steuerelektronikmodul (2) und einem an der Verteilerplatte (1) angebrachten Getriebestecker (17) erstrecken.

6. Hydraulisches Kraftfahrzeug-Getriebesteuergerät nach einem der Ansprüche 4 oder 5,
**dadurch gekennzeichnet,**
- **dass** das Steuerelektronikmodul (2) über eine flexible Leiterplatte (8) an die elektrischen Leiter (9) ankontaktiert ist.

7. Hydraulisches Kraftfahrzeug-Getriebesteuergerät nach Anspruch 4 bis 6,
**dadurch gekennzeichnet,**
- **dass** benachbart des Steuerelektronikmoduls (2) in der Hydraulik-Verteilerplatte (1) ein Kanal (12a) für Hydraulikflüssigkeit angeordnet ist.

8. Hydraulisches Kraftfahrzeug-Getriebesteuergerät nach Anspruch 4 bis 7,
**dadurch gekennzeichnet,**
- **dass** das Steuerelektronikmodul (2) eine metallische Bodenplatte (4) aufweist, welche in die Hydraulik-Verteilerplatte (1) eingegossen ist.

9. Hydraulisches Kraftfahrzeug-Getriebesteuergerät nach Anspruch 4 bis 7,
**dadurch gekennzeichnet,**
- **dass** ein Abschnitt der Oberfläche der Hydraulik-Verteilerplatte (1) die Bodenplatte des Steuerelektronikmoduls (2) bildet, und
- **dass** ein Schaltungsträger (7) des Steuerelektronikmoduls (2) unmittelbar auf diesem Abschnitt der Oberfläche der Hydraulik-Verteilerplatte (1) befestigt ist.

10. Verfahren zur Herstellung eines hydraulischen Kraftfahrzeug-Getriebesteuergeräts mit einer aus Kunststoff bestehenden Hydraulik-Verteilerplatte (1) nach einem der vorhergehenden Ansprüche,
**dadurch gekennzeichnet,**
- **dass** die Leiter (9, 9', 9'') durch Einspritzen oder Vergießen oder Einstemmen oder Einkleben in die Hydraulik-Verteilerplatte (1) integriert werden.

11. Verfahren zur Herstellung eines hydraulischen Kraftfahrzeug-Getriebesteuergeräts mit einer aus Kunststoff bestehenden Hydraulik-Verteilerplatte (1) nach einem der vorhergehenden Ansprüche 1 - 9,
**dadurch gekennzeichnet,**
- **dass** die Leiter (9, 9', 9' ') durch ein MID-Verfahren in die Hydraulik-Verteilerplatte (1) integriert werden.

## Claims

1. A hydraulic gearbox control device in a motor vehicle, having a plastic hydraulic distribution plate (1) in which channels (13a-f) extend for the distribution of hydraulic fluid, and
- in which electrical conductors (9, 9',9") of the gearbox control device are embedded, in particular entirely encapsulated and/or,
- on the surface of which the electrical conductors (9, 9', 9'') of the gearbox control device are attached by metallisation.

2. A hydraulic gearbox control device in a motor vehicle according to Claim 1,
**characterised in that**
- in the case of conductors (9, 9', 9") embedded in the hydraulic distribution plate (1), said conductors are moulded or injected metal wires, pins, belts or pressed screens.

3. A hydraulic gearbox control device in a motor vehicle according to Claims 1 or 2,
**characterised in that**
the hydraulic distribution plate (1) is configured as an injection-moulded MID cable support.

4. A hydraulic gearbox control device in a motor vehicle according one of the preceding Claims,
**characterised in that**
the conductors (9, 9') extend between a control electronics module mounted on the hydraulic distribution plate (1) and at least one solenoid valve (3) for the hydraulic controller.

5. A hydraulic gearbox control device in a motor vehicle according one of the preceding Claims,
**characterised in that**
the conductors (9, 9') extend between a control electronics module mounted on the hydraulic distribution plate (1) and a gearbox connector (17) attached to the distribution plate (1).

6. A hydraulic gearbox control device in a motor vehicle according to one of Claims 4 or 5,
**characterised in that**
the control electronics module (2) is connected to the electrical conductor (9) by means of a flexible conductor plate (8).

7. A hydraulic gearbox control device in a motor vehicle according to Claims 4 to 6,
**characterised in that**
a channel (12a) for hydraulic fluid is arranged adjacent to the control electronics module (2) in the hydraulic distribution plate (1).

8. A hydraulic gearbox control device in a motor vehicle according to Claims 4 to 7,
**characterised in that**
the control electronics module (2) comprises a metallic base plate (4) which is moulded into the hydraulic distribution plate (1).

9. A hydraulic gearbox control device according to Claims 4 to 7
**characterised in that**
- a section of the surface of the hydraulic distribution plate (1) forms the base plate of the control electronics module (2) and
- a circuit carrier (7) of the control electronics module (2) is mounted directly onto this section of the surface of the hydraulic distribution plate (1).

10. Method for producing a hydraulic gearbox control device in a motor vehicle having a plastic hydraulic distribution plate (1) according to one of the preceding Claims
**characterised in that**
the conductors (9,9',9") are integrated into the hydraulic distribution plate (1) by means of injecting, moulding, morticing, or cementing in place.

11. Method for producing a hydraulic gearbox control device in a motor vehicle having a plastic hydraulic distribution plate (1) according to one of the preceding Claims 1 to 9,
**characterised in that**
the conductors (9,9',9'') are integrated into the hydraulic distribution plate (1) by means of an MID method.

## Revendications

1. Appareil de commande hydraulique de boîte de vitesse de véhicule automobile, comportant une plaque de répartition hydraulique (1) constituée de matière synthétique, dans laquelle s'étendent des canaux (13a-f) pour la répartition de liquide hydraulique, et
- dans laquelle sont enrobés, en particulier enrobés complètement sous gaine, des conducteurs électriques (9, 9', 9") de l'appareil de commande de boîte de vitesse, et/ou
- à la surface de laquelle sont déposés par métallisation des conducteurs électriques (9, 9', 9") de l'appareil de commande de boîte de vitesse.

2. Appareil de commande hydraulique de boîte de vitesse de véhicule automobile suivant la revendication 1,
**caractérisé en ce que**,
- dans le cas de conducteurs (9, 9', 9") enrobés dans la plaque de répartition hydraulique (1), il s'agit de fils, de tiges, de bandes, ou de grillages métalliques estampés, qui sont coulés ou injectés.

3. Appareil de commande hydraulique de boîte de vitesse de véhicule automobile suivant l'une des revendications 1 ou 2,
**caractérisé en ce que**
- la plaque de répartition hydraulique (1) est conçue sous la forme d'un support de conducteurs MID coulé par injection.

4. Appareil de commande hydraulique de boîte de vitesse de véhicule automobile suivant l'une des revendications précédentes,
**caractérisé en ce que**
- les conducteurs (9, 9') s'étendent entre un module électronique de commande (2) fixé sur la plaque de répartition hydraulique (1) et au moins une soupape magnétique (3) pour la commande hydraulique.

5. Appareil de commande hydraulique de boîte de vitesse de véhicule automobile suivant l'une des revendications précédentes,
**caractérisé en ce que**
- les conducteurs (9") s'étendent entre un module électronique de commande (2) fixé sur la plaque de répartition hydraulique (1) et une fiche (17) de boîte de vitesse, installée sur la plaque de répartition hydraulique (1).

6. Appareil de commande hydraulique de boîte de vitesse de véhicule automobile suivant l'une des revendications 4 ou 5,
**caractérisé en ce que**
- le module électronique de commande (2) est mis en contact avec les conducteurs électriques (9) au moyen d'une carte de circuits imprimés flexible.

7. Appareil de commande hydraulique de boîte de vitesse de véhicule automobile suivant la revendication 4 à 6,
**caractérisé en ce que**
- un canal (12a) pour fluide hydraulique est disposé dans la plaque de répartition hydraulique (1), au voisinage du module électronique de commande (2).

8. Appareil de commande hydraulique de boîte de vitesse de véhicule automobile suivant la revendication 4 à 7,
**caractérisé en ce que**
- le module électronique de commande (2) présente une plaque de fond métallique (4), qui est coulée dans la plaque de répartition hydraulique (1).

9. Appareil de commande hydraulique de boîte de vitesse de véhicule automobile suivant la revendication 4 à 7,
**caractérisé en ce que**
- une partie de la surface supérieure de la plaque de répartition hydraulique (1) forme la plaque de fond du module électronique de commande (2), et
- un support de circuit (7) du module électronique de commande (2) est fixé directement sur cette partie de la surface de la plaque de répartition hydraulique (1).

10. Procédé de fabrication d'un appareil de commande hydraulique de boîte de vitesse de véhicule automobile, comportant une plaque de répartition hydraulique (1) constituée de matière synthétique, suivant l'une des revendications précédentes,
**caractérisé en ce que**
- les conducteurs (9, 9', 9") sont intégrés dans la plaque de répartition hydraulique (1) par injection ou coulée ou gravure ou collage.

11. Procédé de fabrication d'un appareil de commande hydraulique de boîte de vitesse de véhicule automobile, comportant une plaque de répartition hydraulique (1) constituée de matière plastique, suivant l'une des revendications précédentes 1 à 9,
**caractérisé en ce que**
- les conducteurs (9, 9', 9") sont intégrés dans la plaque de répartition hydraulique (1) au moyen d'un procédé MID.
